(19) Europäisches Patentamt

European Patent Office

Office européen des brevets

(11) **EP 1 629 704 B1**

(12) **EUROPEAN PATENT SPECIFICATION**

(45) Date of publication and mention
of the grant of the patent:
**13.12.2006 Bulletin 2006/50**

(51) Int Cl.:
***H05K 3/42*** *(2006.01)*    ***C25D 21/18*** *(2006.01)*

(21) Application number: **04739481.2**

(22) Date of filing: **01.06.2004**

(86) International application number:
**PCT/EP2004/005874**

(87) International publication number:
**WO 2004/107834 (09.12.2004 Gazette 2004/50)**

(54) **PROCESS FOR FILLING MICRO-BLIND VIAS**

VERFAHREN ZUM AUFFÜLLEN VON MIKROBLINDLÖCHERN

PROCEDE DE REMPLISSAGE DE MICRO-VIAS AVEUGLES

(84) Designated Contracting States:
**AT BE BG CH CY CZ DE DK EE ES FI FR GB GR
HU IE IT LI LU MC NL PL PT RO SE SI SK TR**

(30) Priority: **03.06.2003 DE 10325101**

(43) Date of publication of application:
**01.03.2006 Bulletin 2006/09**

(73) Proprietor: **ATOTECH Deutschland GmbH**
**10553 Berlin (DE)**

(72) Inventors:
• **ÖZKÖK, Akif**
**13349 Berlin (DE)**
• **ROELFS, Bernd, Ottmar**
**14050 Berlin (DE)**

• **IGEL, Oswald**
**14612 Falkensee (DE)**
• **GENTH, Herko**
**13355 Berlin (DE)**
• **MATEJAT, Kai-Jens**
**16727 Vehlefanz (DE)**

(74) Representative: **Albrecht, Thomas**
**Kraus & Weisert**
**Patent- und Rechtsanwälte**
**Thomas-Wimmer-Ring 15**
**80539 München (DE)**

(56) References cited:
**EP-A- 1 426 469        DE-A- 19 525 509**
**US-A- 5 523 001        US-A- 5 976 341**
**US-A1- 2001 023 830    US-A1- 2002 153 254**

**Description**

**Field of the Invention**

The present invention relates to a new process for filling so-called $\mu$-blind vias ($\mu$-BVs) in the production of printed circuit boards. Such $\mu$-BVs serve to create an electrically conductive connection between at least two layers of a printed circuit board. The expression $\mu$-BVs is used when the hole diameter of the vias is less than 0.15 mm (according to IPC) or when the hole density is greater than 1,000 vias/dm$^3$.

**Background of the Invention**

Under normal manufacturing conditions, copper plating electrolytes are subject to gradual aging which leads to a deterioration of the quality of the copper deposition or even to a complete breakdown of the plating process. The useful lifetime of copper electrolytes for general copper plating ranges from weeks to years. However, currently known electrolytes used for filling $\mu$-BVs generally exhibit very short useful lifetimes. Typical useful lifetimes may be as low as 100 Ah/l, i.e., weeks to months. The aging of the electrolytes is generally caused by degradation products of the additives used therein, by the entrainment of extraneous substances and by the leaching of basic materials and photoresists.

This aging of electrolytes causes considerable costs because it necessitates the frequent preparation of fresh solution and the costly disposal of the spent solution. The filling of $\mu$-blind vias differs markedly from other common processes for electroplating printed circuit boards, such as the copper plating of drill holes, in that it requires enhanced performance with respect to process stability and control. In the copper plating of drill holes, the useful lifetimes of the plating baths used may be 500 to 1,000 Ah/l. The enhanced performance with respect to process stability required by electrolytes used not only for metal plating of drill holes and for creating circuit paths, but also for filling $\mu$-BVs may be achieved by specifically adapted organic additives.

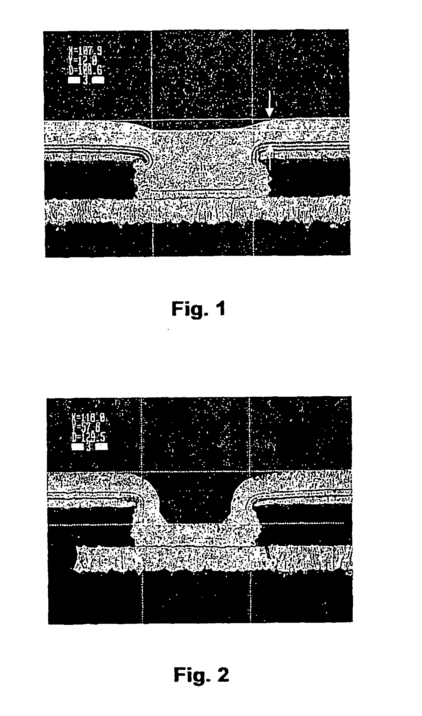

With the known special copper electrolytes, however, $\mu$-BVs can already no longer be filled after operating times of about 100 Ah/l. After such operating period, the $\mu$-blind vias are only traced rather than filled (see Figure 2). Without further treatment, the electroplating bath would have to be replaced at this stage. For standard applications, on the contrary, the bath would still provide an acceptable plating quality.

Several attempts have been made in the prior art to solve the problem of the short useful lifetimes of copper electroplating baths used for filling $\mu$-blind vias:

EP 1 264 918 A1 describes the use of inert anodes in a dummy plating phase in order to maintain and improve the filling capacity of the electrolyte.

According to EP 1 219 729 A1, chemical substances such as formaldehyde or oxidizing agents are used in order to improve the useful lifetime of the electrolyte. According to this document, the mode of action of the additives (in particular, formaldehyde) may be explained in terms of an effect on the equilibrium between brightening agents and their degradation products.

DE 195 25 509 C2 describes the use of an UV/H$_2$O$_2$ oxidation treatment for the reuse or continued use processing of a bath for electroplating articles with metallic coatings. In this process, a bath comprising a metal-specific basic composition and an added organic brightening agent, which is contaminated with operational degradation products, is subjected to an oxidation treatment in which the destruction of the organic brightening agent is accepted. After the oxidation treatment, the organic brightening agent is re-added to the bath. However, as correctly pointed out in DE 198 10 859 A1, DE 195 25 509 C2 does not suggest a specific method for efficient removal of the organic degradation products from the bath. According to Example 1 of that patent, an electrical energy consumption of about 2,000 kWh and an amount of 250 litres of H$_2$O$_2$ (35% solution) is required per m$^3$ of the bath to be processed in order to obtain sufficient purification. Such a high consumption of energy and H$_2$O$_2$, however, jeopardizes the economic viability of the process (see DE 198 10 859 A1, column 1, lines 56 to 64).

Therefore, DE 198 10 859 A1 proposes a process for the treatment of a galvanic bath, in particular, a galvanic nickel bath, in which the UV oxidation process is carried out such that a second, lighter phase is formed, which can be separated simply by a final sorption step or by skimming in a flotation step with subsequent clarification of the skimmed portion, such that a clear solution is recycled while the supernatant is discarded; the cyclic process is continued until all organic substances contained in the bath have been degraded to such an extent that the bath, after treatment in a final sorption step, has again the basic composition (see claim 1 of DE 198 10 859 A1). Due to the additional sorption step, this process is complicated. Moreover, the process requires a "specific process control" (see column 2, lines 1 and 2), i.e., the process cannot easily be adapted to other baths. Rather, the process conditions must be selected specifically and the corresponding parameters need to be determined by laborious preliminary tests.

A further disadvantage of known UV/H$_2$O$_2$ oxidation treatment processes lies in the fact that they require additional treatment units of considerable volume. For example, when filling $\mu$-blind vias in manufacturing printed circuit boards, typically 10 to 15% of the total electrolyte volume is treated. Accordingly, amounts of electrolyte in the range of 3,000 to 12,000 litres must be treated in huge tanks for periods of two to three days. A large part of that time, typically about one day, is needed in order to remove excess $H_2O_2$ by means of UV irradiation since excess $H_2O_2$ would deteriorate the performance of the operative electrolyte.

A method for regenerating of plating baths is also known from US 2002/0153254 A1.

Thus, it is an object of the present invention to provide a process for the galvanic filling of $\mu$-BVs with metals which does not show the aforementioned disadvantages of such processes known in the prior art.

In particular, it is an object of the present invention to provide an improved method of UV/$H_2O_2$ treatment of copper electrolytes for filling $\mu$-blind vias

- which allows the treatment to be carried out in a shorter period of time,

- which can be carried out in smaller treatment units,

- which is more efficient and/or

- which simultaneously allows the copper ion concentration to be controlled and adjusted.

**Description of the Invention**

The present invention provides a process for filling $\mu$-blind vias comprising the following steps:

(i) providing a bath electrolyte for galvanic plating with metallic coatings comprising a copper metal salt and optionally organic additives,

(ii) operating the bath with direct current at a current density of 0.5 to 10 A/dm$^2$ or current pulses at an effective current density of 0.5 to 10 A/dm$^2$,

(iii) withdrawing part of the electrolyte from the galvanic bath,

(iv) adding an oxidizing agent to the part of the electrolyte which has been withdrawn,

(v) optionally irradiating the withdrawn electrolyte with UV light and

(vi) recycling the withdrawn part to the galvanic bath and replacing the organic additives destroyed by the oxidation treatment.

According to a preferred embodiment of the invention, the oxidizing agent added in step (iv) of the process is $H_2O_2$ and the part of the electrolyte withdrawn from the bath is passed through a metal dissolution unit containing copper metal before it is recycled into the galvanic bath in step (vi) of the process.

The invention is explained in more detail by the drawings:

**Figure 1** shows the filling capacity of the bath shortly after it has been prepared, i.e. after an operating time of 2 Ah/l. The layer between the two arrows has been deposited in the test electrolyte. The layers lying thereunder have been deposited by the manufacturer of the test plate and play no role in the filling of $\mu$-blind vias.

**Figure 2** shows the breakdown of the filling capacity after an operating time of 100 Ah/l. The $\mu$-blind via is only traced in its shape, i.e., like with a conventional electrolytic bath for surface plating, 20 $\mu$m of copper are deposited in the via and on the surface.

**Figure 3** shows the filling capacity of the electrolyte after an operating time of 100 Ah/l, subsequent UV/$H_2O_2$ treatment and replenishing of organic additives to the desired concentration range.

**Figure 4** shows the copper and $H_2O_2$ concentrations measured as a function of time in Experiment A of Example 2 (squares = $H_2O_2$; diamonds = Cu).

**Figure 5** shows the copper and $H_2O_2$ concentrations measured as a function of time in Experiment B of Example 2 (squares = $H_2O_2$; diamonds = Cu).

In the process of the invention, copper is added to the electrolyte as copper sulfate pentahydrate (CuSO$_4\cdot$ 5 H$_2$O) or as copper sulfate solution. The operational concentration range of copper is 8 to 60 g/l copper, preferably 15 to 60 g/l, more preferably 25 to 50 g/l.

Sulfuric acid (H$_2$SO$_4$) is added as a 50 to 96% solution. The operational concentration range of sulfuric acid is 40 to 300 g/l $H_2SO_4$, preferably 130 to 250 g/l.

Chloride is added as sodium chloride (NaCl) or as hydrochloric acid solution (HCl). The operational concentration range of chloride is 20 to 150 mg/l chloride, preferably 30 to 60 mg/l.

Furthermore, the bath electrolyte preferably comprises brightening agents, levelling agents and wetting agents as organic additives.

Wetting agents are conventionally oxygen-containing high molecular weight compounds used in concentrations of 0.005 to 20 g/l, preferably 0.01 to 5 g/l. Examples for wetting agents which may be used in the process of the invention are listed in Table 1:

**Table 1.** Wetting Agents

| |
|---|
| carboxymethyl cellulose |
| nonylphenol polyglycol ether |
| octandiol bis-(polyalkylene glycol ether) |
| octanol polyalkylene glycol ether |
| oleic acid polyglycol ester |
| polyethylene glycol polypropylene glycol copolymer |
| polyethylene glycol |
| polyethylene glycol dimethyl ether |
| polypropylene glycol |
| polyvinyl alcohol |
| β-naphthol polyglycol ether |
| stearic acid polyglycol ester |
| stearyl alcohol polyglycol ether |

Brightening agents used are generally sulfur-containing substances such as those listed in Table 2:

**Table 2.** Sulfur Compounds

| |
|---|
| 3-(benzthiazolyl-2-thio)-propyl sulfonic acid, sodium salt |
| 3-mercaptopropane-1-sulfonic acid, sodium salt |
| ethylenedithiodipropyl sulfonic acid, sodium salt |
| bis-(p-sulfophenyl) disulfide, disodium salt |
| bis-(ω-sulfobutyl) disulfide, disodium salt |
| bis-(ω-sulfohydroxypropyl) disulfide, disodium salt |
| bis-(ω-sulfopropyl) disulfide, disodium salt |
| bis-(ω-sulfopropyl) sulfide, disodium salt |
| methyl-(ω-sulfopropyl) disulfide, disodium salt |
| methyl-(ω-sulfopropyl) trisulfide, disodium salt |
| O-ethyl-dithiocarbonic acid S-(ω-sulfopropyl) ester, potassium salt |
| thioglycolic acid |
| thiophosphoric acid O-ethyl-bis-(ω-sulfopropyl) ester, disodium salt |
| thiophosphoric acid tris-(ω-sulfopropyl) ester, trisodium salt |

As levelling agents, polymeric nitrogen compounds (for example, polyamines or polyamides) or nitrogen-containing sulfur compounds, for example, thiourea derivatives or lactam alkoxylates, as described in DE 38 36 521 C2, can be used. The concentrations of the used substances lie in the range of 0.1 to 100 ppm.

4

Furthermore, oligomeric and polymeric phenazonium derivates, which are described in DE 41 26 502 C1, can also be used. Further substances which are used for filling $\mu$-blind vias are dyes based on an aminotriphenylmethane structure, such as malachite green, rosalinine or crystal violet.

The bath is operated with direct current at a current density of 0.5 to 10 A/dm$^2$, preferably 0.5 to 2.5 A/dm$^2$, or with current pulses at an effective current density of 0.5 to 10 A/dm$^2$. The effective current density is calculated according to the following formula:

$$I_{eff} = \frac{\left| I_{forward} \right| \cdot t_{forward} - \left| I_{backward} \right| \cdot t_{backward}}{t_{forward} + t_{backward}}$$

Improvements of the deposition can be achieved by complex pulse sequences or by combined pulse- and DC-sequences.

In the process of the invention, an oxidizing agent is added to a part of the electrolyte withdrawn from the bath and this part is optionally irradiated with UV light. This treatment results in a complete destruction of the organic components and, thereby, in the purification of the basic electrolyte. By subsequently adding the organic additives, the filling capacity of the electrolyte is maintained and the $\mu$-blind vias can be filled. The process of the invention is significantly more efficient than the activated charcoal treatment known in the state of the art and does not require any waste disposal. Therefore, it is not necessary to prepare fresh electrolytes, which results in considerable cost savings.

Contrary-to the process described in DE 198 10 859 A1, the treatment of copper plating baths according to the present invention does not result in the formation of separate phases or unwanted deposits of the reacted organic additives. The specific additives of the electrolyte allow a transformation of the organic additives to volatile oxidation products such as $CO_2$ and $N_2$ without formation of residues.

Thus, the process of the invention can be carried out without any means for physical separation of the oxidization products of the organic additives. In particular, the process can be carried out without treating the electrolyte by physical separation, such as filtration or centrifugation, chemisorption or physisorption, either before the oxidization treatment or thereafter.

The oxidizing agent is preferably used in an amount which is sufficient in order to reduce the TOC concentration (i.e., the total concentration of organic components) from 1,000 to 1,500 mg/l down to 50 to 300 mg/l. It can also be useful to use an amount of oxidizing agent which is sufficient to reduce the TOC concentration to 50% of the value before the oxidation treatment.

Preferably, $H_2O_2$ is used as oxidizing agent. The latter is preferably used as a 30% aqueous solution, for example in an amount of 3 to 30 ml per litre of plating bath.

Furthermore, oxygen can be used as an oxidizing agent. This can also be the atmospheric oxygen dissolved in the bath. In the latter case, the separate addition of an oxidizing agent may become redundant.

In particular, the process of the invention can be carried out with $H_2O_2$ as the only oxidizing agent; thus, it can be carried out without gaseous oxidizing agents such as ozone.

The irradiation is carried out with devices known per se, for example, UV lamps with a wave length range of 100 nm to 700 nm, preferably 200 nm to 550 nm. The radiation power is generally 0.5 to 20 W per litre of bath, preferably 1 to 5 W per litre of bath.

In the process of the invention, there are preferably used such organic additives which, upon irradiation, decompose with formation of $CO_2$ and/or $N_2$. The additives listed in Tables 1 and 2 as well as the aforementioned nitrogen compounds fulfil these requirements.

The anodes used can be, for example, inert anodes without redox system (i.e., without $Fe^{2+/3+}$ system). In the case of acidic copper, DC and AC electrolytes, soluble anodes can also be used.

The process of the invention can be carried out according to various embodiments which are described hereinafter:

In the first embodiment, the electrolyte is mixed in a UV chamber with small amounts of $H_2O_2$ (i.e., amount of 0.01 to 0.1 ml/l of $H_2O_2$ (30% solution)) and irradiated continuously. In this case, the amount of electrolyte which is exchanged (i.e. withdrawn) is limited because the electrolyte must be free of $H_2O_2$ when it leaves the chamber. In this embodiment of the process of the invention, the amount of electrolyte exchanged is 10 to 50 l/h and preferably about 30 l/h.

In a second embodiment of the process of the invention, only a part of the electrolyte is withdrawn and treated in a UV chamber with $H_2O_2$ and UV light. In general, the withdrawn part amounts to 10 to 50% of the total volume and preferably about 30% relative to the total amount of the electrolyte.

The duration of the treatment depends on the volume, the amount of oxidizing agent, the irradiation power of the lamp and the temperature. The plant must be designed such that the total volume of the electrolyte can be purified over its useful lifetime. The useful lifetime depends on the performance required of the electrolyte.

In a third embodiment of the process, no $H_2O_2$ treatment is carried out. In this embodiment, it is accepted that the purification of the electrolyte is not as effective as in the above two embodiments. However, the process according to the third embodiment can be carried out continuously.

The use of an oxidizing agent in the first and second embodiment described above results in an accelerated degradation of organic additives (as compared with the third embodiment). These additives must be replaced in order to maintain the filling capacity of the electrolyte. However, as described above, it is an important advantage of the process of the invention, that the bath does not need to be replaced completely.

According to a particularly preferred embodiment of the process of the invention, the oxidizing agent added in step (iv) of the process is $H_2O_2$ and the part of the electrolyte withdrawn from the galvanic bath is passed through a metal dissolution unit containing copper metal after it is subjected to the $UV/H_2O_2$ treatment and before it is recycled into the bath in step (vi) of the process.

A plant for carrying out the process of the invention according to the particularly preferred embodiment comprises, inter alia, a treatment unit (wherein the $UV/H_2O_2$ treatment takes place), a $H_2O_2$ dosing unit connected to the treatment unit, and a metal dissolution unit connected to the treatment unit. The part of the electrolyte withdrawn from the bath first passes through the treatment unit and subsequently passes through the metal dissolution unit before it is recycled to the galvanic bath.

A plant for carrying out the process of the invention can also comprise a cooling unit.

The metal dissolution unit is generally a container and contains copper metal. The copper metal can be provided in the form of anode material, pellets, rods or particles. The metal dissolution unit is preferably a column through which the treated electrolyte exiting the treatment unit can pass.

A part of the galvanic bath, typically 10 to 15%, is withdrawn and subjected to a $UV/H_2O_2$ treatment, wherein comparatively large amount of $H_2O_2$ are added and the solution is continuously irradiated with UV light in order to decompose the organic substances in the electrolyte. The decomposition of the organic substances can be controlled by measuring the TOC concentration, i.e., the total concentration of organic components. After the TOC concentration has reached a predetermined target value, the addition of $H_2O_2$ is stopped. At this stage, the treated electrolyte contains comparatively large amounts of $H_2O_2$. The excess $H_2O_2$ must be destroyed in order to ensure that the electrolyte functions properly in the filling of μ-blind vias. For this reason, the $H_2O_2$ concentration must typically be lowered to values of about 0.5 g/l $H_2O_2$.

According to the particularly preferred embodiment of the invention, the $H_2O_2$ concentration is initially lowered only to a value of about 3 to 5 g/l by further irradiation with UV light. The treated electrolyte with an $H_2O_2$ concentration in that range is then passed through the metal dissolution unit where excess $H_2O_2$ is partly destroyed due to the catalytic effect of the surfaces of the copper metal contained therein with release of oxygen. Furthermore, $H_2O_2$ is consumed in the metal dissolution unit in a redox reaction wherein the $H_2O_2$ is reduced to water and the copper metal is oxidized to copper ion. This latter redox reaction proceeds according to the following equation:

$$H_2O_2 + Cu + 2\,H^+ \rightarrow Cu^{2+} + 2\,H_2O \qquad (1)$$

In the reaction according to this equation, 1 g/l $H_2O_2$ can release a theoretical maximum of 1.85 g/l $Cu^{2+}$.

The catalytic destruction of $H_2O_2$ at the copper metal surface, on the other hand, proceeds according to the following equation:

$$H_2O_2 \rightarrow \tfrac{1}{2}\,O_2 + 2\,H_2O \qquad (2)$$

This reaction is much faster than the destruction of $H_2O_2$ by irradiation with UV light.

The proportions in which $H_2O_2$ reacts according to equation (1) and according to equation (2), respectively, depends on such factors as temperature, pressure, purity of the electrolyte and nature of the catalytic metal surface.

Thus, passing the treated electrolyte through the metal dissolution unit containing copper metal results in a significant acceleration of the destruction of excess $H_2O_2$ as compared to the destruction by irradiation with UV light alone. In a process wherein excess $H_2O_2$ is destroyed by irradiation with UV light, this process step may typically take about one day. In the particularly preferred embodiment of the process of the invention using the aforementioned metal dissolution unit, the time required for the destruction of excess $H_2O_2$ can be reduced by, for example, 20 to 40%. The actual rate of $H_2O_2$ destruction achieved by employing a metal dissolution unit depends on various factors such as the initial and desired final amount of $H_2O_2$, the nature of the catalytic metal surface, and the flow rate.

As indicated above, the reaction of $H_2O_2$ according to the above equation (1) leads to the release of copper ions. This has the added advantage that the concentration of copper ion is increased and that the loss of copper ion which occurs not only as a result of the desired deposition of copper metal on the printed circuit boards to be plated, but also as a result of the unwanted entrainment of electrolyte, is compensated. This is particularly advantageous when high copper concentrations in the plating bath, for example 35 to 60 g/l, are employed.

In order to further accelerate the destruction of excess $H_2O_2$, it is possible to provide in the metal dissolution unit or as part thereof additional catalytic surfaces of materials which catalyse the reaction indicated above in equation (2). Suitable materials for this purpose are, for example, titanium, ruthenium, rhodium, palladium, osmium, iridium, platinum, titanium oxides, mixed titanium oxides, iridium oxides, mixed iridium oxides as well as mixtures of any of these materials.

**Examples**

The invention will be illustrated further by the following examples:

Example 1

An acidic copper plating bath with the following composition is used: copper: 44 g/l, sulfuric acid: 130 g/l, chloride: 40 mg/l, basic levelling agent Cupracid HLF™ (Atotech Deutschland GmbH): 20 ml/l and brightening additive Cupracid

BL™ (Atotech Deutschland GmbH): 0.5 ml/l.

The brightening additive contains a substance from Table 2 and the basic levelling agent consists of a wetting agent from Table 1 as well as a nitrogen compound (polyamide).

The bath is operated up to 100 Ah/l until the filling of $\mu$-blind vias breaks down. Thereafter, the bath is treated with $UV/H_2O_2$ and the organic components are replaced in order to make up the initial composition indicated above. Before and after the treatment, a test plate is run in order to demonstrate the filling capacity. The plates are run in a direct current process with 1.5 A/dm$^2$ in a vertical standard tank with soluble copper anodes. The parameters of the $UV/H_2O_2$ treatment were as follows:

| | |
|---|---|
| Volume: | 600 l copper bath Cupracid HLF™ |
| UV lamp: | 12 kW; 200 nm |
| $H_2O_2$ dosing: | 27 l/h or 14 l/h |
| Electrolyte circulation: | 10.5 m$^3$/h |
| TOC before treatment: | 1180 mg/l |
| TOC after treatment: | 81 mg/l |

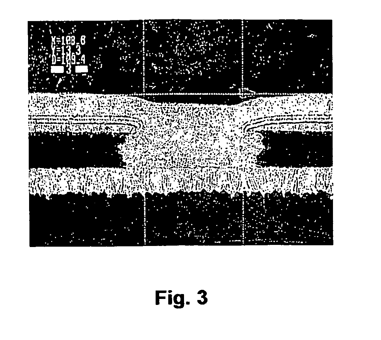

Figures 1 to 3 show the sequence of tests.

Example 2

A series of four experiments (A to D) was carried out as follows:

In Experiment A, 5 ml/l $H_2O_2$ solution (35%) and 1 ml/l levelling agent Cupracid HLF™ were added to 280 l of copper electrolyte solution. In a first bypass, the electrolyte solution was passed through a UV reactor operated at an irradiation power of 1 kW (Enviolett S™ manufactured by A.C.K.). The turnover through the UV reactor was 650 l/h.

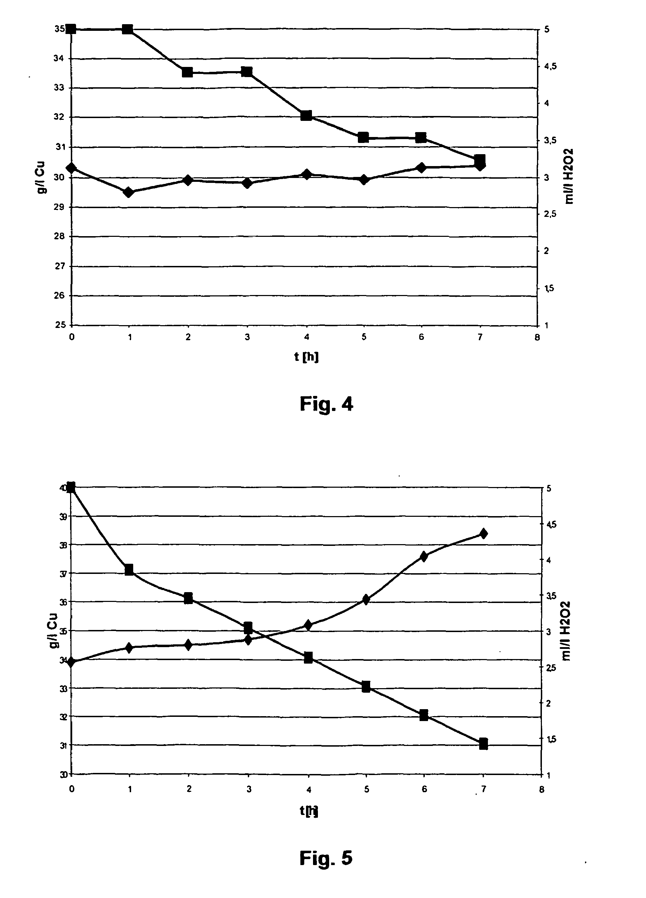

To evaluate the process conditions, copper and $H_2O_2$ concentrations were determined at intervals of one hour (copper was determined volumetrically with EDTA solution and $H_2O_2$ was determined volumetrically with $KMnO_4$ solution). The copper and $H_2O_2$ concentrations measured at various times are shown in Table 3 below and in Figure 4.

In Experiment B, the process was run in the same way as in Experiment A, except, that, in a second bypass, the electrolyte solution was additionally passed, in parallel, through a copper column filled with 6 kg copper pellets (length 18 mm, diameter 7 mm, total surface about 40 dm$^2$). The copper column had a diameter of 90 mm, a length of 250 mm and a capacity of about 1.5 l. The turnover through the copper column was 360 l/h. The copper and $H_2O_2$ concentrations were measured as before and are also shown in Table 3 and in Figure 5.

Without the copper column (Experiment A), the $H_2O_2$ concentration was lowered over a period of seven hours from 5 g/l only to 3.2 g/l while the copper concentration remained constant at 30 g/l.

With the copper column (Experiment B), the $H_2O_2$ concentration was reduced over a period of seven hours from 5 g/l to 1.4 g/l, whereas the copper concentration increased from 34 g/l by 4 g/l to 38 g/l. Reducing the $H_2O_2$ concentration from 5 g/l to 3 g/l required a total treatment time of three hours. Over this three hour period, the copper concentration increased by 0.8 g/l.

Thus, the time required to reduce the $H_2O_2$ concentration from 5 g/l to 3 g/l was reduced by four hours (i.e., by 57%) when a copper column was used. Over the same time period, a slight increase in the copper concentration was observed.

In Experiment C, the process was run in the same way as in Experiment B, except that the amount of copper pellets was reduced to 3 kg. Furthermore, in Experiment D, the process was run in the same way as in Experiment C, except that a titanium grating (0.5 m$^2$) coated with mixed iridium oxide was additionally provided inside the copper column. The concentrations of $H_2O_2$ and copper were again measured at regular intervals. The results are also shown in Table 3.

With the additional grating coated with mixed iridium oxide, a faster and greater decrease in the $H_2O_2$ concentration is achieved than without the grating. At the same time, the partial replacement of copper pellets by the titanium grating coated with mixed iridium oxide can make the increase in the copper concentration slower.

**Table 3**. Copper and $H_2O_2$ concentrations measured in Experiments A to D

| | Time | A | B | C | D |
|---|---|---|---|---|---|
| | | (without Cu) | (6 kg Cu) | (3 kg Cu) | (3 kg Cu + Ti) |
| concentration of Cu (g/l) after | t = 0 h | 30.0 | 34.0 | 34.0 | 34.0 |
| | t = 3 h | | 34.8 | 34.0 | 34.0 |
| | t = 7 h | 30.0 | 38.0 | 34.6 | 34.5 |
| concentration of $H_2O_2$ (g/l) after | t = 0 h | 5.0 | 5.0 | 5.0 | 5.0 |
| | t = 3 h | | 3.0 | 3.9 | 3.2 |
| | t = 7 h | 3.2 | 1.4 | 3.0 | 2.1 |

**Claims**

1.  Process for filling $\mu$-blind vias comprising the following steps:

    (i) providing a bath electrolyte for galvanic plating with metallic coatings comprising a copper metal salt and optionally organic additives,
    (ii) operating the bath with direct current at a current density of 0.5 to 10 A/dm$^2$ or current pulses at an effective current density of 0.5 to 10 A/dm$^2$,
    (iii) withdrawing part of the electrolyte from the galvanic bath,
    (iv) adding an oxidizing agent to the part of the electrolyte which has been withdrawn,
    (v) optionally irradiating the withdrawn electrolyte with UV light and
    (vi) recycling the withdrawn part to the galvanic bath and replacing the organic additives destroyed by the oxidation treatment,

    wherein the oxidizing agent added in step (iv) is $H_2O_2$ and the part of the electrolyte withdrawn from the bath is passed through a metal dissolution unit containing copper metal before it is recycled into the bath in step (vi) of the process.

2.  Process according to claim 1 wherein the bath electrolyte for galvanic plating comprises 8 to 60 g/l copper, 40 to 300 g/l sulfuric acid and 20 to 150 mg/l chloride, and the organic additives comprise brightening agents, wetting agents and further additives selected from polyamides, polyamines, lactam alkoxylates, thioureas, oligomeric and polymeric phenazonium derivates and aminotriphenylmethane dyes.

3.  Process according to claim 1 or 2 wherein the oxidizing agent is added in an amount which is sufficient in order to reduce the TOC concentration from 1,000 to 1,500 mg/l down to 50 to 300 mg/l.

4.  Process according to claim 1 wherein the irradiation is carried out at a wave length in the range of 200 nm to 550 nm.

5.  Process according to claim 1 wherein the irradiation power is 0.5 to 20 W per litre of bath, preferably 1 to 5 W per litre of bath.

6.  Process according to claim 1 wherein polymers which form $CO_2$ upon irradiation are used as organic additives.

**7.** Process according to claim 1 wherein an acidic copper electrolyte is used as electrolyte.

**8.** Process according to claim 1 wherein the galvanic bath is operated with inert anodes without redox system.

**9.** Process according to claim 1 wherein an acidic copper electrolyte is used as electrolyte and soluble anodes are used as anodes.

**10.** Process according to claim 1 wherein the copper metal in the metal dissolution unit is in the form of anode material, pellets, rods or particles.

**11.** Process according to claim 1 wherein the metal dissolution unit further contains catalytic surfaces comprising a material selected from the group consisting of titanium, ruthenium, rhodium, palladium, osmium, iridium, platinum, titanium oxides, mixed titanium oxides, iridium oxides, mixed iridium oxides as well as mixtures of any of these materials.

**12.** Process according to claim 1 wherein the metal dissolution unit is a column through which the treated part of the electrolyte withdrawn from the bath is passed.

**Patentansprüche**

**1.** Verfahren zum Auffüllen von μ-Blind-Vias, umfassend die folgenden Stufen:

(i) Bereitstellen eines Bad-Elektrolyten zur galvanischen Beschichtung mit metallischen Überzügen, umfassend ein Kupfermetallsalz und optional organische Zusätze,
(ii) Betrieb des Bades mit Gleichstrom bei einer Stromdichte von 0,5 bis 10 A/dm$^2$ oder Strompulsen mit einer effektiven Stromdichte von 0,5 bis 10 A/dm$^2$,
(iii) Entnahme eines Teils des Elektrolyten aus dem galvanischen Bad,
(iv) Zugabe eines Oxidationsmittels zu dem entnommenen Teil des Elektrolyten,
(v) gegebenenfalls Bestrahlen des entnommenen Elektrolyten mit UV-Licht und
(vi) Rückführen des entnommenen Teils in das galvanische Bad und Ergänzen der durch die Oxidationsbehandlung zerstörten organischen Zusätze,

wobei das in Stufe (iv) zugegebene Oxidationsmittel $H_2O_2$ ist und der aus dem Bad entnommene Teil des Elektrolyten durch eine Metallauflösungseinheit, enthaltend Kupfermetall, geführt wird, bevor er in der Stufe (vi) des Verfahrens in das galvanische Bad zurückgeführt wird.

**2.** Verfahren nach Anspruch 1, wobei der Badelektrolyt zur galvanischen Beschichtung 8 bis 60 g/l Kupfer, 40 bis 300 g/l Schwefelsäure und 20 bis 150 mg/l Chlorid umfasst und die organischen Zusätze Aufhellungsmittel, Benetzungsmittel und weitere Zusätze, ausgewählt aus Polyamiden, Polyaminen, Lactamalkoxylaten, Thioharnstoffen, oligomeren und polymeren Phenazoniumderivaten und Aminotriphenylmethan-Farbstoffen, umfassen.

**3.** Verfahren nach Anspruch 1 oder 2, wobei das Oxidationsmittel in einer Menge zugesetzt wird, die ausreichend ist, um die TOC-Konzentration von 1.000 bis 1.500 mg/l auf 50 bis 300 mg/l zu verringern.

**4.** Verfahren nach Anspruch 1, wobei die Bestrahlung bei einer Wellenlänge im Bereich von 200 nm bis 550 nm durchgeführt wird.

**5.** Verfahren nach Anspruch 1, wobei die Bestrahlungsleistung 0,5 bis 20 W pro Liter Bad, bevorzugt 1 bis 5 W pro Liter Bad, beträgt.

**6.** Verfahren nach Anspruch 1, wobei als organische Zusätze Polymere verwendet werden, die bei Bestrahlung $CO_2$ bilden.

**7.** Verfahren nach Anspruch 1, wobei ein saurer Kupferelektrolyt als Elektrolyt verwendet wird.

**8.** Verfahren nach Anspruch 1, wobei das galvanische Bad mit inerten Anoden ohne Redoxsystem betrieben wird.

**9.** Verfahren nach Anspruch 1, wobei ein saurer Kupferelektrolyt als Elektrolyt verwendet wird und lösliche Anoden als Anoden verwendet werden.

**10.** Verfahren nach Anspruch 1, wobei das Kupfermetall in der Metallauflösungseinheit in Form von Anodenmaterial, Pellets, Stäben oder Teilchen vorliegt.

**11.** Verfahren nach Anspruch 1, wobei die Metallauflösungseinheit des Weiteren katalytische Oberflächen enthält, die ein Material umfassen, das ausgewählt ist aus der Gruppe bestehend aus Titan, Rhutenium, Rhodium, Palladium, Osmium, Iridium, Platin, Titanoxiden, Titanmischoxiden, Iridiumoxiden, Iridiummischoxiden sowie Gemischen dieser Materialien.

**12.** Verfahren nach Anspruch 1, wobei die Metallauflösungseinheit eine Säule ist, durch die der behandelte Teil des aus dem Bad entnommenen Elektrolyten geleitet wird.

**Revendications**

**1.** Procédé pour remplir des μ trous borgnes comprenant les étapes suivantes :

    (i) produire un électrolyte pour bain de déposition galvanique avec revêtements métalliques comprenant un sel de métal cuivre et facultativement des additifs organiques,
    (ii) traiter le bain avec un courant continu à une densité de courant de 0,5 à 10 A/dm$^2$ ou des impulsions de courant à une densité de courant effectif de 0,5 à 10 A/dm$^2$,
    (iii) retirer une partie de l'électrolyte du bain galvanique,
    (iv) ajouter un agent oxydant à la partie de l'électrolyte qui a été retirée,
    (v) irradier facultativement l'électrolyte retirée avec une lumière UV et
    (vi) recycler la partie retirée vers le bain galvanique et remplacer les additifs organiques détruits par le traitement d'oxydation,

dans lequel l'agent oxydant ajouté à l'étape (iv) est du $H_2O_2$ et la partie de l'électrolyte retirée du bain est passée à travers une unité de dissolution métallique contenant du métal cuivre avant d'être recyclée dans le bain à l'étape (vi) du procédé.

**2.** Procédé selon la revendication 1, dans lequel l'électrolyte pour bain de déposition galvanique comprend 8 à 60 g/l de cuivre, 40 à 300 g/l d'acide sulfurique et 20 à 150 mg/l de chlorure, et les additifs organiques comprennent des agents d'avivage, des agents mouillants et d'autres additifs sélectionnés parmi les polyamides, les polyamines, les alcoxylates de lactame, les thio-urées, les dérivés de phénazonium oligomériques et polymériques et les teintures d'aminotriphénylméthane.

**3.** Procédé selon la revendication 1 ou 2, dans lequel l'agent oxydant est ajouté en une quantité suffisante pour réduire la concentration de matières organiques totales d'entre 1 000 et 1 500 mg/l à entre 50 et 300 mg/l.

**4.** Procédé selon la revendication 1, dans lequel l'irradiation est réalisée à une longueur d'onde dans la plage de 200 nm à 550 nm.

**5.** Procédé selon la revendication 1, dans lequel le pouvoir d'irradiation est de 0,5 à 20 W par litre de bain, de préférence de 1 à 5 W par litre de bain.

**6.** Procédé selon la revendication 1, dans lequel les polymères qui forment le $CO_2$ lors de l'irradiation sont utilisés comme additifs organiques.

**7.** Procédé selon la revendication 1, dans lequel un électrolyte de cuivre acide est utilisé comme électrolyte.

**8.** Procédé selon la revendication 1, dans lequel le bain galvanique est traité avec des anodes inertes sans système redox.

**9.** Procédé selon la revendication 1, dans lequel un électrolyte de cuivre acide est utilisé comme électrolyte et des anodes solubles sont utilisées comme anodes.

**10.** Procédé selon la revendication 1, dans lequel le métal cuivre dans l'unité de dissolution métallique est sous la forme de particules, de tiges, de comprimés ou de matériaux d'anode.

**11.** Procédé selon la revendication 1, dans lequel l'unité de dissolution métallique comprend en outre des surfaces catalytiques contenant un matériau sélectionné parmi le groupe constitué par le titane, le ruthénium, le rhodium, le palladium, l'osmium, l'iridium, le platine, les oxydes de titane, les oxydes de titane mélangés, les oxydes d'iridium, les oxydes d'iridium mélangés ainsi que les mélanges de l'un quelconque de ces matériaux.

**12.** Procédé selon la revendication 1, dans lequel l'unité de dissolution métallique est une colonne à travers laquelle la partie traitée de l'électrolyte retirée du bain est passée.

**Fig. 1**

**Fig. 2**

**Fig. 3**

**Fig. 4**

**Fig. 5**